# EUROPEAN PATENT SPECIFICATION

(11) **EP 2 568 790 B1**
(45) Date of publication and mention of the grant of the patent: **04.09.2013**
(21) Application number: 11180187.4
(22) Date of filing: 06.09.2011
(51) Int. Cl.: H05K 7/20

(54) **Apparatus and method**
Vorrichtung und Verfahren
Appareil et procédé

(43) Date of publication of application: 13.03.2013
(60) Divisional application: 12174921.2
(73) Proprietor: ABB Research Ltd., 8050 Zürich (CH)
(72) Inventor: Agostini, Bruno, 8953 Dietikon (CH); Habert, Mathieu, 4310 Rheinfelden (CH); Kauranen, Matti, 02750 Espoo (FI); Elo, Markku, 02750 Espoo (FI)
(74) Representative: Holmström, Stefan Mikael

(56) References cited:
- EP-A1- 2 031 332
- EP-A1- 2 327 947
- EP-A2- 1 909 549
- EP-A2- 2 361 006
- WO-A1-01/20713
- WO-A1-2007/009868
- DE-A1- 10 157 671
- DE-A1- 10 250 604
- US-A1- 2009 284 923

## Description

### BACKGROUND OF THE INVENTION

### FIELD OF THE INVENTION

This invention relates to an apparatus and to a method, and especially to a cooling solution for an apparatus including electric components.

### DESCRIPTION OF PRIOR ART

Previously there is known an apparatus with a heat exchanger having a first heat transfer element comprising a base plate for an electric component, and with channels for transferring a heat load from the base plate into fluid in the channels. The fluid is passed on via the channels to a second heat exchanger where the fluid is cooled. At least some of the channels protrude from a surface of the base plate. Such a heat exchanger is known from EP - A - 2 031 332, for instance.

A problem with the above mentioned heat exchanger is insufficient heat storage capacity especially for handling temporary peaks in the amount of heat generated by electric components.

Previously there is known from EP - A - 2 361 006, WO - A - 2007/009868, EP - A - 1 909 549, DE - A - 101 57 671 and US - A - 2009/0284923 various solutions for utilizing a phase change material in a cooling apparatus.

A problem with the above mentioned solutions is, however, that temporary temperature peaks cannot be efficiently handled.

### SUMMARY OF THE INVENTION

An object of the present invention is to solve the above mentioned drawback and to provide a novel cooling solution. This object is achieved with the method of claim 1 and the apparatus of claim 2.

The use of a phase change material which during a phase change absorbs heat makes it possible to obtain a solution with a more efficient cooling. Such a phase change material can be arranged in a well-protected space between at least two channels in order to provide temporarily a higher cooling capacity due to a phase change of the material. Once there is no longer a need for a higher cooling capacity and the temperature reaches a level below the phase change temperature, the phase change material can return to the original physical state in order for it to be ready to absorb excess heat during a following peak in the heat generation. Adjustment in order to keep the temperature such that the phase change material works optimally ensures that the phase change material works efficiently.

### BRIEF DESCRIPTION OF DRAWINGS

In the following the present invention will be described in closer detail by way of example and with reference to the attached drawings, in which

Figures 1 to 2 illustrate a first embodiment of an apparatus,

Figure 3 illustrates an alternative for providing the apparatus of Figures 1 and 2 with a phase change material,

Figure 4 illustrates the temperature difference obtained with the apparatus of Figures 1 and 2,

Figure 5 illustrates a second embodiment of an apparatus, and

Figures 6 to 8 illustrate the effect of phase change material at different ambient temperatures.

### DESCRIPTION OF AT LEAST ONE EMBODIMENT

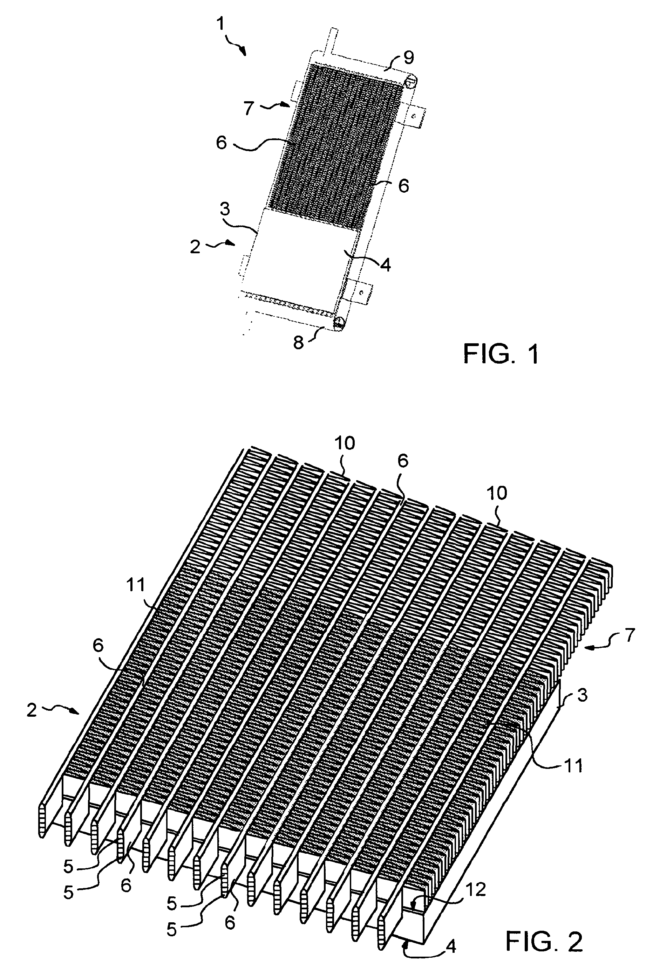

Figures 1 to 2 illustrate a first embodiment of an apparatus 1. The apparatus comprises a first heat transfer element 2 comprising a base plate 3 with a first surface 4 for receiving one or more electric components that require cooling during their use in order to avoid an excessive temperature raise. The first heat transfer element 2 also comprises a plurality of channels 5 for transferring a received heat load into a fluid circulating in said channels. From Figure 2 it can be seen that in this embodiment the channels 5 are arranged in pipes 6, which are spaced apart and have internal walls separating a plurality of channels 5 from each other. The pipes may be MPE (MultiPort Extruded) pipes which have been manufactured by extruding aluminum, for instance. In Figure 1 the apparatus 1 is seen from a direction where the base plate 3 is on top of the pipes 6 and Figure 2 illustrates only some of the parts of the apparatus 1 seen from a direction where the pipes 6 are on top of the base plate 3.

The apparatus comprises a second heat transfer element 7, which receives fluid from the first heat transfer element 2. In this embodiment the pipes 6 extend all the way from a first manifold 8 arranged in the proximity of the first heat transfer element 2 to a second manifold 9 arranged in the proximity of the second heat transfer element 7. The second heat transfer element 7 comprises the pipes 6 and fins 10 which extend between the channels 5, in this case the walls of the pipes 6 containing the channels. An airstream passing through the second heat transfer element 7 can therefore transfer heat away from the fluid in the pipes 6.

In the illustrated embodiment the apparatus 1 works as a thermosyphon. The pipes 6 partly penetrate into the base plate 3 (working as an evaporator) such that some of the channels 5 located in the pipes are evaporator channels containing fluid that is heated when the first heat transfer element 2 receives heat from an electric component. The heated fluid (or possibly vapour at this stage) flows towards the second heat transfer element 7 (working as a condenser), where air passing between the channels 5 (located inside the pipes 6) cools the fluid. The second manifold 9 may be implemented as a tank, in other words a closed space with a fluid connection to all channels 5 of the pipes 6. The fluid may therefore exit the evaporator channels into the manifold and return downwards towards the first manifold 8 via those channels 5 of the pipes 6 that are located outside the base plate 3 and function as condenser channels. The first manifold 8 can be implemented similarly to the second manifold 9, in other words, as a tank with a fluid connection to each channel 5 of the pipes. Therefore, the fluid entering the first manifold 8 via the condenser channels can proceed via the evaporator channels to a new flow cycle. Such a thermosyphon is advantageous as it can be utilized for cooling an electric apparatus without a need for a pump to obtain the desired fluid circulation.

An alternative to the illustrated embodiment is to separate the first and second heat transfer element 2 and 7 from each other. In that case the parallel channels 5 do not extend all the way between the first and second heat transfer element 2 and 7. Instead, an additional manifold is arranged in the upper part of the first heat transfer element 2 to receive fluid from all of the channels 5 in the first heat transfer element 2. Similarly, a second additional manifold is arranged in the lower part of the second heat transfer element 7 to pass fluid to all channels 5 of the second heat transfer element 7. These additional manifolds can be connected to each other with one or more pipes for passing fluid from the first heat transfer element 2 (evaporator) to the second heat transfer element 7 (condenser), and the second manifold 9 can be connected to the first manifold 8 via one or more additional pipes for returning the fluid from the second heat transfer element 7 (condenser) to the first heat transfer element 2 (evaporator).

Irrespective of which of the implementations is used for the thermosyphon, the first heat transfer element 2 may be provided with a phase change material 11 which during operation of the appara4tus enters a phase change to absorb heat in order to cool the base plate 2 and one or more electric components attached to the base plate. Such a phase change material 11 may be arranged against a second surface 12 of the base plate 3, preferably substantially over the entire surface area of the base plate 3. In practice the second surface 12 of the base plate 3 is in the illustrated embodiment provided with channels 5 contained in pipes 6 and with fins 10 extending between these channels. However, there are a lot of empty spaces delimited by the second surface 12, the channels 5 and the fins 10, and preferably, as many of these empty spaces as possible are filled with the phase change material. In such a solution the phase change material is efficiently protected. Heat is conducted directly from the base plate 3 to the pipes 6 containing channels 5 and fluid, and in addition, from the base plate 3 via the fins 10 to the pipes 6. In order to work as efficiently as possible, the phase change material should be located thermally closer to heat source than the "main" cooling system is. In this way the phase change material reacts faster than the main cooling system to temperature changes.

A Phase Change Material (PCM) is a substance, which by changing phase at a certain constant temperature, called phase change temperature, is capable of storing and releasing large amounts of energy at constant temperature. Phase change typically occurs as melting and solidifying or as changes in the crystal structure of materials where the phase change takes place from solid to solid. Heat is absorbed or released when the material changes from one phase to another. Initially the temperature of a phase change material 11 rises as the phase change material absorbs heat. However, when a phase change material reaches a phase change temperature at which it changes phase, it absorbs large amounts of heat at a constant temperature until all material is transformed to the new phase. When the ambient temperature around the material subsequently falls, the phase change material returns to its pervious physical state, and releases its stored latent heat.

A large number of phase change materials are available on the market in any required temperature range at least from from -114°C up to 1010°C. The most common type of phase change materials is the solid - liquid. There are, however, other types of phase change materials and some materials exhibit solid - solid phase changes, in which the crystalline structure is altered at a certain temperature. To be a useful PCM, a material should ideally meet several criteria:

- release and absorb large amounts of energy when freezing and melting,

- have a fixed and clearly determined phase change temperature,

- remain stable and unchanged over many freeze/melt cycles,

- be non-hazardous, - be economical, and

- should not cause corrosion problems to other materials

In the illustrated embodiment the apparatus 1 is preferably used in an upright position, due to which a phase change material 11 with a solid - solid phase change is preferable. Such a phase change material 11 can be inserted directly between the channels 5 and the fins 10 as illustrated in Figure 2. Examples of suitable materials are salt hydrates, fatty acids, esters, and various paraffins (such as octadecane).

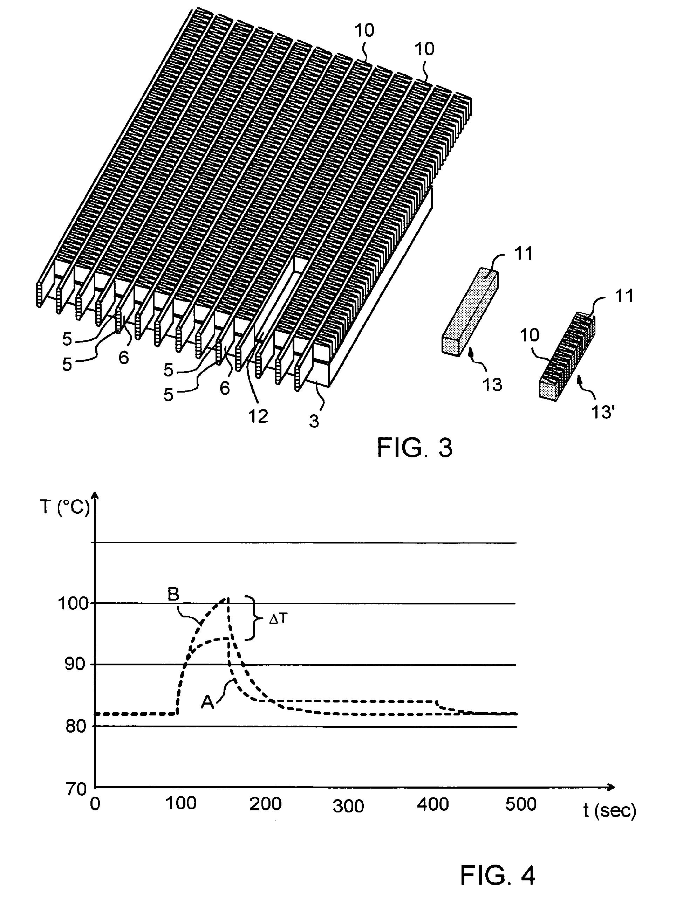

Figure 3 illustrates an alternative for providing the apparatus of Figures 1 and 2 with a phase change material.

In Figure 3 a container 13 is used for encapsulating the phase change material 11 before it is arranged in its place on the second surface 12 of the base plate. This gives a greater freedom in selecting a suitable phase change material. Solid - liquid phase change materials, for instance, can be used as the phase change material can be hermetically sealed. A suitable material to be used in the embodiment of Figure 3 is salt hydrate such as PlusiCE X80 available from Phase Change Material Products Limited, for instance.

If solid - liquid material is used, the "container" may be implemented to consist of the baseplate 3, the pipes 6 and a lid which create a container or tank for the phase change material.

In the embodiment of Figure 3, no fins 10 are arranged at the location of the second surface 12 reserved for the container 13. However, if it is advantageous to use fins 10 also in connection with one or more containers 13 with phase change material 11, then the fins 10 can be arranged inside the container 13 together with the phase change material 11. A container 13' containing both phase change material 11 and fins 10 is also illustrated in Figure 3.

The fins 10 should be (thermally) attached to the base plate 4 via the second surface 12, so that the heat from the heat source can come via baseplate 4 to fins 10 and further to the phase change material. The fins 10 provide a good and even contact to the phase change material, so that the heat distribution to the phase change material is as even as possible.

Some of the available solid-solid phase change materials have a very poor thermal conductivity, which means that the effective thickness (=heat path) can typically be only a few millimeters. It is important that the heat path from heat source to the phase change material is as short as possible and the contact area to the phase change material is as big as possible. The structure described above utilizing fins to conduct heat from the base plate into the phase change material is very good from this point of view.

Figure 4 illustrates the temperature difference obtained with the apparatus of Figures 1 and 2.

Figure 4 illustrates the temperature T (the temperature probe is located on the surface 4 just below the heat source) at different moments of time t (seconds) when the apparatus of Figure 1 is used for removing heat from electronic components of a frequency converter (can be used other electric devices too), in other words a drive used for controlling the speed of an electric motor, for instance. The ambient temperature has been selected to be optimal for the phase change material in question, in this case 40°C. Curve B illustrates the temperature behaviour when no phase change material is in use, and the curve A illustrates the temperature behaviour when the spaces between the channels 5, the fins 10 and the second surface 12 of the base plate are filled with a phase change material. In this case, the temperature peak is reduced (ΔT) by about 6.4°C.

For semiconductor components, for instance, a reduction of the temperature change has a significant impact on the expected lifetime of the component in question. Practical tests have shown that when temperature peaks occur cyclically, a reduction of the temperature change during the peak from 30°C to 25°C increases the number of cycles without malfunctions by about 4 to 5 times.

Also the peak temperature will be lower (in this example from 77-71°C, which also makes the lifetime longer.

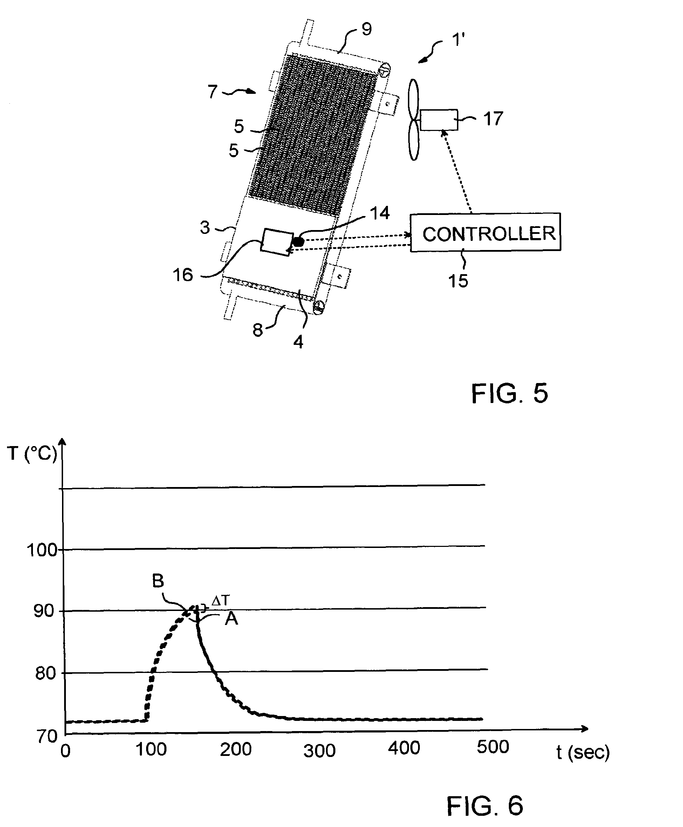

Figure 5 illustrates a second embodiment of an apparatus 1'. The apparatus 1' is very similar to the one explained in connection with Figures 1 and 2. Therefore the embodiment of Figure 5 will mainly be explained by pointing out the differences between these embodiments.

In Figure 5 a similar thermosyphon with a base plate 3, a second heat transfer element 7, channels 5 and manifolds 8 and 9 is used as in Figure 1. The second surface of the base plate (not shown in Figure 5) is also provided with a phase change material.

Phase change materials are usually most efficiently utilized at an ambient temperature which is dependent on the selected material in question. Each phase change material has a different phase change temperature and can be selected depending on the application. Properties and the amount of phase change material is always dependent on the design (system), heat load, allowed temperatures and cooling conditions (ambient temperature or cooling temperature). To achieve the best results, the phase change temperature of the phase change material should be selected accordingly.

The best results in using a phase change material can be obtained by ensuring that the ambient temperature is optimal for the selected phase change material. Figure 5 illustrates two alternatives that can be used simultaneously or independently of each other for ensuring that the ambient temperature is optimal. In both alternatives a temperature sensor 14 is utilized for measuring the ambient temperature and information about the ambient temperature is provided to a controller 15, which may be implemented with circuitry or as a combination of circuitry and a computer program. In many cases the controller is integrated to circuitry of electric device, so that it does not require any extra components and/or printed circuit boards. In these cases the functionality is done with software.

The temperature sensor 14 may be attached to an electric component 16, the base plate 3, the phase change material or the second heat transfer element 7. In general, the temperature sensor should preferably be placed as close to the actual heat source as possible in order to detect changes as fast as possible. In any case, the controller receives information about the measured temperature, which is used by the controller 15 to determine if the measured temperature is above or below a reference temperature (the optimal ambient temperature for the selected phase change material in question).

The first alternative is that the controller 15 adjusts the cooling efficiency in order to try to maintain the ambient temperature at the optimal level. In that case an adjustable fan 17 may be utilized, for instance, in order to increase or decrease the amount of air flowing through the second heat transfer element 7. If the measured temperature is too high, the speed of the fan 17 is increased, and if the measured temperature is too low, the speed of the fan 17 is reduced. Depending on the practical implementation, other types of adjustable cooling may be employed, in which case the adjustment may affect the speed of a pump or the position of a valve regulating a flow, for instance. If a pump is utilized the cooling media flowing between the channels of the second heat transfer element may be a suitable liquid such as water, for instance.

The second alternative is that the controller 15 adjusts the amount of heat produced by the electric component 16. In that case the controller 15 controls the electric component or components to operate in a mode (at a lower efficiency level, for instance) where they produce less heat during periods when the measured temperature is too high. In the case of a frequency converter, for instance, this might lead to a situation where the entire potential of the frequency converter cannot be utilized during such periods, but permanent damage to the components of the frequency converter can in any case be avoided. The use of the phase change material makes it possible to allow a bigger heat peak than in solutions without the phase change material.

Figures 6 to 8 illustrate the effect of phase change material at different temperatures. Figures 6 to 8 are very similar to Figure 4. Thus they illustrate the temperature T at different moments of time t (seconds) when the apparatus of Figure 1 is used for removing heat from electronic components. Curve B illustrates the temperature behaviour when no phase change material is in use, and the curve A illustrates the temperature behaviour when the spaces between channels 5, the fins 10 and the second surface 12 of the base plate are filled with a phase change material. The used phase change material is the same in Figures 4 and 6 to 8.

In the case of Figure 4 the ambient temperature was selected to be optimal for the phase change material, in other words 40°C. In that case the temperature peak was reduced (ΔT) with about 6.4 °C when phase change material was in use.

In the case of Figure 6 the ambient temperature is no longer optimal, but instead 30°C. In that case the temperature peak was reduced (ΔT) with about 1.2 °C when phase change material was in use.

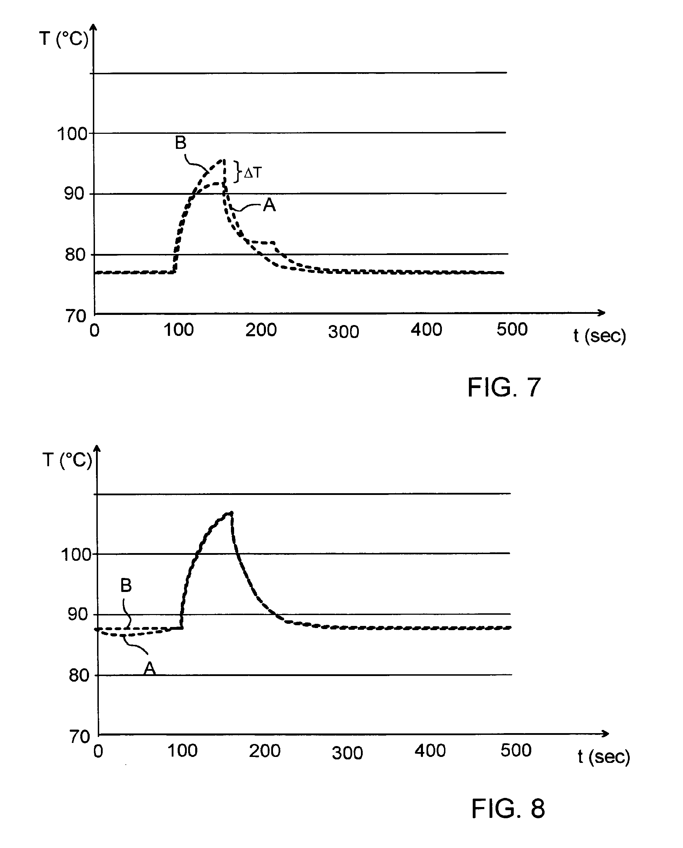

In the case of Figure 7 the ambient temperature is 35°C. In that case the temperature peak was reduced (ΔT) with about 3.9 °C when phase change material was in use.

Finally, in the case of Figure 8 the ambient temperature is 45°C. As can be seen from Figure 8, the phase change material changes phase very early at this temperature, and after about 75 seconds the phase change has already taken place.

Based on a comparision of Figures 4 and 6 to 8 it is clear that in order to work efficiently the phase change material needs to be used at an ambient temperature optimal for the material in question, otherwise there is not much sense in utilizing phase change material at all. Based on this discovery, it is clear that a solution where the "main" cooling system is adjusted in order to keep the temperature at a suitable level for the phase change material, as explained in connection with Figure 5 is very advantageous, because then it can be ensured that once a peak occurs in the heat generation, the phase change material will work efficiently and quickly to reduce the negative impact such a peak can have on the apparatus in question. If the pump (and liquid) is used instead of the fan (and air), there is analogue from ambient temperature to coolant (eg. water) temperature.

It is to be understood that the above description and the accompanying figures are only intended to illustrate the present invention. It will be obvious to a person skilled in the art that the invention can be varied and modified without departing from the scope of the claims.

## Claims

1. A method for cooling an apparatus, **characterized in that** the method comprises:
measuring (14) a temperature at an electric component (16) which is arranged to a first surface (4) of a base plate (3) with a phase change material (11) arranged at a second surface (12) of the base plate such that the phase change material is thermally connected to the electric component (16), said temperature measuring is carried out with a temperature sensor attached to the electric component, the base plate or the phase change material,
comparing said measured temperature with a reference value selected depending on the properties of the phase change material (11) in question in order to reduce the negative impact of a peak in the amount of heat generated by the electric component by reducing the temperature change during the peak and the height of the peak temperature, and
adjusting a cooling arrangement (17) in order to increase or decrease the cooling provided with said cooling arrangement (17), in order to control the measured temperature to change towards said reference value.

2. An apparatus, **characterized in that** the apparatus comprises:
an electronic component (16) which is arranged to a first surface (4) of a base plate (3) with a phase change material (11) arranged at a second surface (12) of the base plate such that the phase change material is thermally connected to the electronic component (16),
a temperature sensor (14) arranged to measure a temperature at the electric component (16), said temperature sensor is attached to the electric component, the base plate or the phase change material and
a controller (15) comparing said measured temperature with a reference value selected depending on the properties of the phase change material (11) in question in order to reduce the negative impact of a peak in the amount of heat generated by the electric component by reducing the temperature change during the peak and the height of the peak temperature, and
adjusting a cooling arrangement (17) in order to increase or decrease the cooling provided with said cooling arrangement (17), or adjusting the amount of heat produced by the electric component (16) by controlling the electric component to operate in a mode producing less heat, in order to control the measured temperature to change towards said reference value.

## Patentansprüche

1. Verfahren zur Kühlung einer Vorrichtung, **dadurch gekennzeichnet , dass** das Verfahren aufweist:
Messung (14) einer Temperatur an einer elektrischen Komponente (16), die auf einer ersten Oberfläche (4) einer Grundplatte (3) angeordnet ist, wobei ein Phasenwechselmaterial (11) auf einer zweiten Oberfläche (12) der Grundplatte derart angeordnet ist, dass das Phasenwechselmaterial mit der elektrischen Komponente (16) thermisch verbunden ist, welche Temperaturmessung mittels eines Temperatursensors durchgeführt wird, der an der elektrischen Komponente, der Grundplatte oder dem Phasenwechselmaterial befestigt ist,
Vergleichung der besagten gemessenen Temperatur mit einem Referenzwert, der je nach den Eigenschaften des betreffenden Phasenwechselmaterials (11) ausgewählt wird, um den negativen Einfluss einer Spitze in der von der elektrischen Komponente erzeugten Wärmemenge zu verringern, indem die Temperaturänderung während der Spitze und die Höhe der Spitzentemperatur vermindert werden, und
Einstellung einer Kühlanordnung (17) zur Steigerung oder Verringerung der mit der besagten Kühlanordnung (17) vorgesehenen Kühlung, um die gemessene Temperatur zu steuern, sich gegen den besagten Referenzwert zu ändern.

2. Vorrichtung, **dadurch gekennzeichnet, dass** die Vorrichtung aufweist:
eine elektronische Komponente (16), die auf einer ersten Oberfläche (4) einer Grundplatte (3) angeordnet ist, wobei ein Phasenwechselmaterial (11) auf einer zweiten Oberfläche (12) der Grundplatte derart angeordnet ist, dass das Phasenwechselmaterial mit der elektronischen Komponente (16) thermisch verbunden ist,
einen Temperatursensor (14), der angeordnet ist, eine Temperatur an der elektrischen Komponente (16) zu messen, welcher Temperatursensor an der elektrischen Komponente, der Grundplatte oder dem Phasenwechselmaterial befestigt ist, und
einen Regler (15), der die besagte gemessene Temperatur mit einem Referenzwert vergleicht, der je nach den Eigenschaften des betreffenden Phasenwechselmaterials (11) ausgewählt wird, um den negativen Einfluss einer Spitze in der von der elektrischen Komponente erzeugten Wärmemenge zu verringern, indem die Temperaturänderung während der Spitze und die Höhe der Spitzentemperatur vermindert werden, und
der eine Kühlanordnung (17) einstellt, die mit der besagten Kühlanordnung (17) vorgesehene Kühlung zu erhöhen oder zu steigern, oder die von der elektrischen Komponente (16) erzeugte Wärmemenge einstellt, indem die elektrische Komponente gesteuert wird, in einem Modus zu arbeiten, der weniger Wärme erzeugt, um die gemessene Temperatur zu steuern, sich gegen den besagten Referenzwert zu ändern.

## Revendications

1. Procédé de refroidissement d'un appareil, **caractérisé en ce que** le procédé comprend :
la mesure (14) d'une température au niveau d'un composant électrique (16) qui est agencé sur une première surface (4) d'une plaque de base (3) avec un matériau à changement de phase (11) agencé au niveau d'une deuxième surface (12) de la plaque de base de sorte que le matériau à changement de phase est relié thermiquement au composant électrique (16), ladite mesure de température étant effectuée avec un capteur de température attaché au composant électrique, à la plaque de base ou au matériau à changement de phase,
la comparaison de ladite température mesurée avec une valeur de référence sélectionnée en fonction des propriétés du matériau à changement de phase (11) en question afin de réduire l'impact négatif d'un pic de la quantité de chaleur générée par le composant électrique en réduisant la variation de température pendant le pic et la hauteur de la température crête, et
l'ajustement d'un agencement de refroidissement (17) afin d'augmenter ou de diminuer le refroidissement réalisé par ledit agencement de refroidissement (17), afin de commander la température mesurée pour qu'elle change vers ladite valeur de référence.

2. Appareil, **caractérisé en ce que** l'appareil comprend :
un composant électronique (16) qui est agencé sur une première surface (4) d'une plaque de base (3) avec un matériau à changement de phase (11) agencé au niveau d'une deuxième surface (12) de la plaque de base de sorte que le matériau à changement de phase est relié thermiquement au composant électronique (16),
un capteur de température (14) agencé pour mesurer une température au niveau du composant électrique (16), ledit capteur de température étant attaché au composant électrique, à la plaque de base ou au matériau à changement de phase, et
un contrôleur (15) comparant ladite température mesurée avec une valeur de référence sélectionnée en fonction des propriétés du matériau à changement de phase (11) en question afin de réduire l'impact négatif d'un pic dans la quantité de chaleur générée par le composant électrique en réduisant la variation de température pendant le pic et la hauteur de la température crête, et
l'ajustement d'un agencement de refroidissement (17) afin d'augmenter ou de diminuer le refroidissement réalisé par ledit agencement de refroidissement (17), ou l'ajustement de la quantité de chaleur produite par le composant électrique (16) en commandant le composant électrique pour qu'il fonctionne dans un mode produisant moins de chaleur, afin de commander la température mesurée pour qu'elle change vers ladite valeur de référence.
